**Europäisches Patentamt**

**European Patent Office**

**Office européen des brevets**

(11) Veröffentlichungsnummer: **0 324 525**
**A2**

# (12) EUROPÄISCHE PATENTANMELDUNG

(21) Anmeldenummer: **89200048.0**

(51) Int. Cl.⁴: **H03F 3/50**

(22) Anmeldetag: **10.01.89**

(30) Priorität: **14.01.88 DE 3800803**

(43) Veröffentlichungstag der Anmeldung:
**19.07.89 Patentblatt 89/29**

(84) Benannte Vertragsstaaten:
**DE FR GB IT NL**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB IT NL**

(72) Erfinder: **Horl, Manfred**
**Fehnweg 39**
**D-2000 Hamburg 62(DE)**

(74) Vertreter: **Hartmann, Heinrich; Dipl.-Ing. et al**
**Philips Patentverwaltung GmbH**
**Wendenstrasse 35 Postfach 10 51 49**
**D-2000 Hamburg 1(DE)**

(54) **Verstärkerschaltung.**

(57) Die Erfindung betrifft eine Verstärkerschaltung mit einem ersten Transistor, dessen Emitter mit einem Lastwiderstand verbunden ist. Bei einer solchen Schaltung werden die Verzerrungen dadurch verringert, daß an den Emitter des ersten Transistors die Basis eines zweiten Transistors geschaltet ist, dessen Emitter über einen ersten Widerstand mit einem Punkt konstanten Potentials verbunden ist und dessen Kollektor mit dem Eingang einer Stromspiegelschaltung gekoppelt ist, deren Ausgang mit dem Emitter des ersten Transistors gekoppelt ist.

FIG.2

## Verstärkerschaltung

Die Erfindung betrifft eine Verstärkerschaltung mit einem ersten Transistor, dessen Emitter mit einem Lastwiderstand verbunden ist. Schaltungen dieser Art sind als "Emitterfolger" allgemein bekannt.

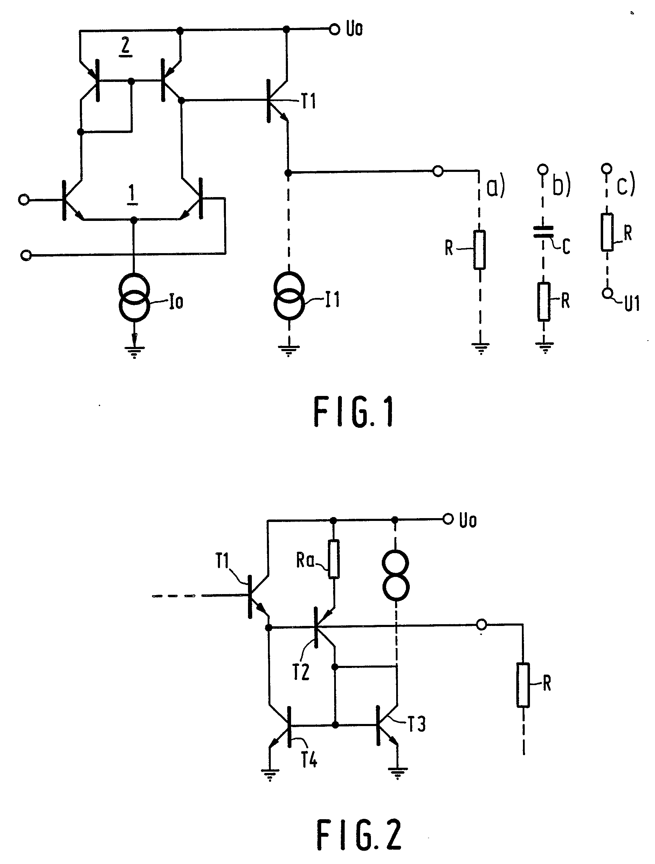

Fig. 1 zeigt einen einfachen bekannten Operationsverstärker, wobei der npn-Transistor T1 als Emitterfolger wirkt. Die Basis dieses Transistors ist mit dem Ausgang eines Differenzverstärkers verbunden, der ein emittergekoppeltes Transistorpaar 1 umfaßt, dessen Emitterzuleitung über eine Stromquelle Io mit Masse und dessen Kollektoren mit den Ein- und Ausgängen einer Stromspiegelschaltung 2 verbunden sind, deren Ausgang an die Basis des Transistors T1 angeschlossen ist.

Der Emitter des Transistors T1 ist mit einem Lastwiderstand R verbunden. Der Lastwiderstand kann zwischen den Emitter und Masse geschaltet sein (Fall a) oder zwischen den Emitter und ein konstantes Potential U1 (Fall c), das beispielsweise die Hälfte der Speisespannung Uo entsprechen kann; in diesen Fällen fließt über den Lastwiderstand R ein Gleichstrom. Der Lastwiderstand R kann aber auch über einen Kondensator C mit dem Emitter des Transistors T1 verbunden sein (Fall b); in diesem Fall fließt über den Lastwiderstand R nur ein Wechselstrom. In den Fällen b und teilweise c muß der Emitter des Transistors T1 über einen Gleichstrompfad, vorzugsweise eine Gleichstromquelle I1 mit Masse verbunden sein - wie in Fig.1 gestrichelt angedeutet.

Damit der Transistor T1 nicht stromlos wird, muß der Emitter-Gleichstrom des Transistors T1 stets größer sein als der Emitter-Wechselstrom. Daraus resultiert ein relativ großer Maximalwert des Emitter-Stroms, was voraussetzt, daß der Basis-Strom des Transistors T1 eine entsprechenden Wert annehmen kann. Dies setzt - insbesondre bei kleinem Stromverstärkungsfaktor des Transistors T1 und relativ niedrigem Gleichstrom von der Gleichstromquelle Io eine relativ große Spannungsdifferenz zwischen den Basen der Transistoren des Transistorpaares 1 voraus, beispielsweise 7 mV. Bei einer derart großen Aussteuerung ist der Zusammenhang zwischen der Spannungsdifferenz am Eingang des emittergekoppelten Transistorpaares 1 und dem Ausgangstrom des Verstärkers 1 ,2 schon nichtlinear, so daß sich Signalverzerrungen ergeben.

Solche Verzerrungen ergeben sich auch, wenn die Basis des Transistors T1 auf andere Weise gespeist wird, beispielsweise direkt durch eine Signalquelle. Da sich die Basis-Emitter-Spannung des Transistors T1 nämlich nicht-linear mit dem Emitter-Strom dieses Transistors ändert, hängt die Spannung am Lastwiderstand nichtlinear von der Spannung an der Basis des Trabsistors T1 ab, was ebenfalls Verzerrungen zur Folge hat.

Es ist Aufgabe der vorliegenden Erfindung, die Verzerrungen bei einer Schaltung der eingangs genannten Art zu verringern. Diese Aufgabe wird erfindugsgemäß dadurch gelöst, daß an den Emitter des ersten Transistors die Basis eines zweiten Transistors geschaltet ist, dessen Emitter über einen ersten Widerstand mit einem Punktkonstanten Potentials verbunden ist und dessen Kollektor mit dem Eingang einer Stromspiegelschaltung gekoppelt ist, deren Ausgang mit dem Emitter des ersten Transistors gekoppelt ist.

Bei der Erfindung werden die Verzerrungen dadurch verringert, daß die Stromaussteuerung des ersten Transistors - bei unveränderter Signalspannung am Lastwiderstand R -verringert wird. Da der zweite Transistor nämlich den entgegengesetzten Leitfähigkeitstyp hat wie der erste Transistor, ändert sich der Kollektorstrom des zweiten Transistors gegensinnig zum Emitter-Strom des ersten Transistors. Dieser gegensinnig veränderliche Strom wird über den Stromspiegel dem Emitter des ersten Transistors zugeführt. Der Emitter-Strom des ersten Transistors setzt sich also aus zwei Komponenten zusammen: einem Strom über den Lastwiderstand und einem dazu gegensinnig veränderlichen Strom über den Stromspiegelausgang, so daß die Änderungen der beiden Ströme sich mehr oder weniger kompensieren und der Emitter-Strom des Transistors T1 im wesentlichen konstant bleibt. Aus diesem Grund erzeugt der erste Transistor selbst weniger Verzerrungen. Der Ruhestrom für diesen Transistor kann niedriger gewählt werden, und auch der Signalstrom kann niedriger sein, so daß ein gegebenenfalls vorgeschalteter Verstärker, beispielsweise entsprechend Fig. 1 - ebenfalls weniger Verzerrungen erzeugt.

Eine bevorzugte Weiterbildung der Erfindung sieht vor, daß mit dem Eingang der Stromspiegelanordnung zusätzlich eine Gleichstromquelle gekoppelt ist. Diese Weiterbildung ist insbesondre dann von Nutzen, wenn über den Lastwiderstand, beispielsweise wegen eines dazu in Serie geschalteten Kondensators, kein Gleichstrom fließen kann.

Eine Weiterbildung der Erfindung sieht vor, daß der Widerstand in der Emitterzuleitung des zweiten Transistors T2 und das Stromspiegelverhältnis so gewählt sind, daß der Signalstrom am Ausgang des Stromspiegels den gleichen Wert hat wie der Signalstrom über den Lastwiderstand R.

In diesem Fall ist der vom Stromspiegelausgang dem ersten Transistor zugeführte Signal-Strom genauso groß wie der Signal-Strom über den Lastwiderstand, und der Emitter-Strom des Transistors T1 enthält keine Signalkomponente mehr.

Die Erfindung wird nachstehend an Hand der Zeichnung näher erläutert. Es zeigen:

Fig. 1 die bekannte Schaltung,

Fig. 2 eine Ausführungsbeispiel der Erfindung,

Der Emitter des Transistors T1 ist bei der Schaltung nach Fig. 2 ebenso wie bei der Schaltung nach Fig. 1 mit dem Lastwiderstand R direkt oder über einen Kondensator verbunden. Der Lastwiderstand R ist mit seinem weiteren Anschluß an Masse oder einen anderen Punkt konstanten Potentials angeschlossen. An den Emitter des Transistors T1 ist darüberhinaus die Basis eines zweiten Transistors T2 angeschlossen, der den entgegengesetzten Leitfähigkeitstyp hat wie der erste Transistor T1, also ein pnp-Transistor. Der Emitter des Transistors T2 ist über einen Widerstand Ra mit der Versorgungsspannung Uo verbunden. Der Kollektor dieses Transistors ist mit dem Eingang eines Stromspiegels verbunden, der aus zwei npn-Transistoren T3 und T4 aufgebaut ist, wobei der Kollektor des Transistors T3 mit seiner Basis, der Basis des Transistors T4 und dem Kollektor des Transistors T2 verbunden ist. Die Emitter der beiden Transistoren T3 und T4 sind mit Masse verbunden, und der Kollektor des Transistors T4 ist mit dem Emitter des Transistors T1 verbunden.

Wenn sich die Spannung am Emitter des Transistors T1 ändert und demgemäß eine Änderung des Stromes durch den Arbeitswiderstand R hervorruft, ändert sich der Emitter-Strom des Transistors T2 durch den Widerstand Ra gegensinnig dazu. Dieser gegensinnig veränderte Strom wird über die Stromspiegelanordnung dem Emitter des Transistors T1 zugeführt. Wenn der Strom über den Lastwiderstand R zunimmt, nimmt der über den Ausgang des Stromspiegels T3, T4 geführte Gleichstrom ab und umgekehrt. Infolgedessen wird der Signal-Strom im Emitter des ersten Transistors T1 mehr oder weniger kompensiert.

Wenn der Arbeitswiderstand R in seiner Größe vorgegeben ist - was insbesondre bei integrierten Schaltungen nicht-von vornherein gelten muß, läßt sich eine vollständige Kompensation erreichen, wenn der Widerstand Ra gleich dem Arbeitswiderstand R ist und wenn das Stromspiegelverhältnis 1 : 1 ist. Wenn der Widerstand Ra dem Widerstand R nicht entspricht, läßt sich gleichwohl eine vollständige Kompensation erreichen, wenn das Strompiegelverhältnis entsprechend gewählt wird, d.h. wenn die Transistoren T3 und T4 ein entsprechendes Flächenverhältnis haben.

Durch die vollständige Kompensation des über den Arbeitswiderstand R fließenden Signal-Stroms wirkt die in Fig. 2 dargestellte Schaltung wie ein Verstärker mit unendlich hohem Eingangswiderstand. Der über den Emitter fließende Signal-Strom ist dabei Null, so daß die dadurch bewirkten Verzerrungen entfallen. Die Basis des Transistors T1 kann an den Ausgang eines Verstärkers angeschlossen sein, der mit dem Verstärker 1, 2 nach Fig. 1 identisch ist. Da über den Emitter kein - bzw. bei nicht vollständiger Kompensation ein verringerter - Signalstrom fließt ist auch der Basis-Signal-Strom entweder Null oder zumindest verringert. Der Basis-Gleichstrom, der größer sein muß als der Basis-Signalstrom, kann dann ebenfalls verringert werden. Infolgedessen kann auch die Differenzspannung am Eingang des Differenzverstärkers 1, 2 kleiner sein, was niedrigere Verzerrungen zur Folge hat.

Die Verringerung der Verzerrungen - jedenfalls soweit sie durch den Transistor T1 verursacht sind - ergibt sich allerdings auch dann, wenn die Basis des Transistors T1 an eine andere Schaltung angeschlossen ist, beispielsweise direkt an eine Signalquelle.

Damit der Transistor T1 auch dann einen Strom führt, wenn er mit dem Lastwiderstand über einen Kondensator verbunden ist, wird dem Eingang des Stromspiegels - wie gestrichelt angedeutet - zusätzlich der Gleichstrom einer Gleichstromquelle I2 zugeführt.

**Ansprüche**

1. Verstärkerschaltung mit einem ersten Transistor, dessen Emitter mit einem Lastwiderstand verbunden ist,
dadurch gekennzeichnet, daß an den Emitter des ersten Transistors (T1) die Basis eines zweiten Transistors (T2) geschaltet ist, der den entgegengesetzten Leitfähigkeitstyp hat wie der erste Transistor, dessen Emitter über einen ersten Widerstand mit einem Punkt konstanten Potentials verbunden ist und dessen Kollektor mit dem Eingang einer Stromspiegelschaltung (T3,T4) gekoppelt ist, deren Ausgang mit dem Emitter des ersten Transistors gekoppelt ist.

2. Verstärkerschaltung nach einem der Ansprüche 1,
dadurch gekennzeichnet, daß mit dem Eingang der Stromspiegelanordnung (T3,T4) zusätzlich eine Gleichstromquelle (I2) gekoppelt ist.

3. Verstärkerschaltung nach einem der vorhergehenden Ansprüche,
dadurch gekennzeichnet, daß der Widerstand (Ra) in der Emitterzuleitung des zweiten Transistors (T2) und das Stromspiegelverhältnis so gewählt sind, daß der Signalstrom am Ausgang (T4) des Stromspiegels den gleichen Wert hat wie der Signalstrom über den Lastwiderstand (R)

FIG.1

FIG.2